# EUROPEAN PATENT SPECIFICATION

(11) **EP 2 860 532 B1**
(45) Date of publication and mention of the grant of the patent: **21.09.2016**
(21) Application number: 14187546.8
(22) Date of filing: 02.10.2014
(51) Int. Cl.: G01P 15/125, G01C 19/5783, G01L 1/14

(54) **Mems sensor device with multi-stimulus sensing and method of fabrication**
MEMS-Sensoreinrichtung mit mehreren Sensorstimulus und Herstellungsverfahren
Dispositif de capteur MEMS multi-stimulus de détection et procédé de fabrication

(30) Priority: 14.10.2013 US 201314053236
(43) Date of publication of application: 15.04.2015
(73) Proprietor: Freescale Semiconductor, Inc., Austin, TX 78735 (US)
(72) Inventor: Liu, Lianjun, Chandler, AZ Arizona 85286 (US); Bates, James S., Paradise Valley, AZ Arizona 85253 (US); Chowdhury, Mamur, Phoenix, AZ Arizona 85042 (US); Monk, David J., Mesa, AZ Arizona 85215 (US); Taheri, Babak A., Tempe, AZ Arizona 85284 (US)
(74) Representative: Freescale law department - EMEA patent ops

(56) References cited:
- EP-A1- 2 506 017
- WO-A1-2013/064632
- US-A1- 2012 299 127

## Description

### Technical Field of the Invention

The present invention relates generally to microelectromechanical (MEMS) sensor devices. More specifically, the present invention relates to a MEMS sensor device with multiple stimulus sensing capability and a method of fabricating the MEMS sensor device.

### Background of the Invention

Microelectromechanical systems (MEMS) devices are semiconductor devices with embedded mechanical components. MEMS devices include, for example, pressure sensors, accelerometers, gyroscopes, microphones, digital mirror displays, micro fluidic devices, and so forth. MEMS devices are used in a variety of products such as automobile airbag systems, control applications in automobiles, navigation, display systems, inkjet cartridges, and so forth.

### Brief Description of the Drawings

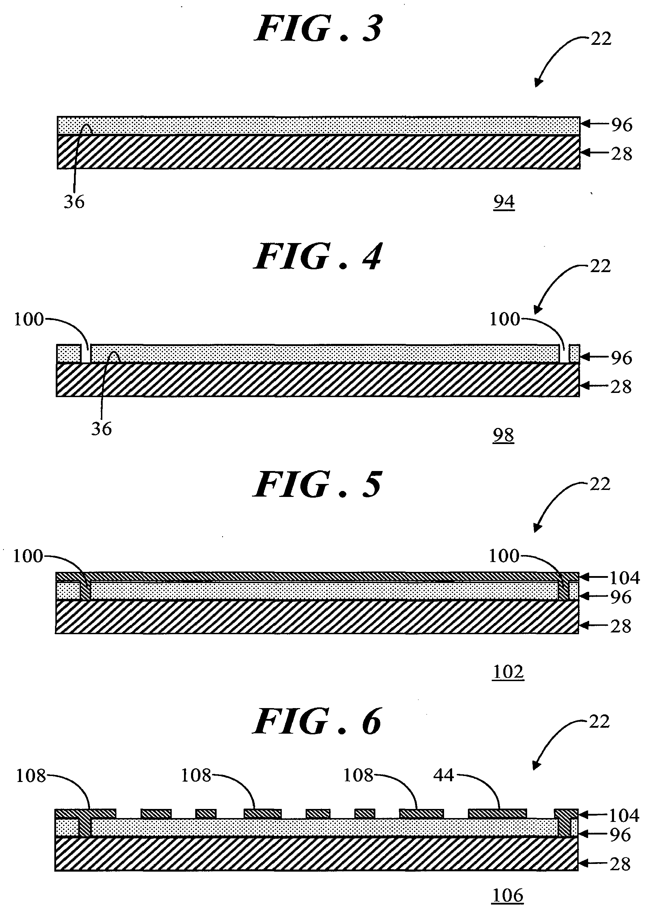

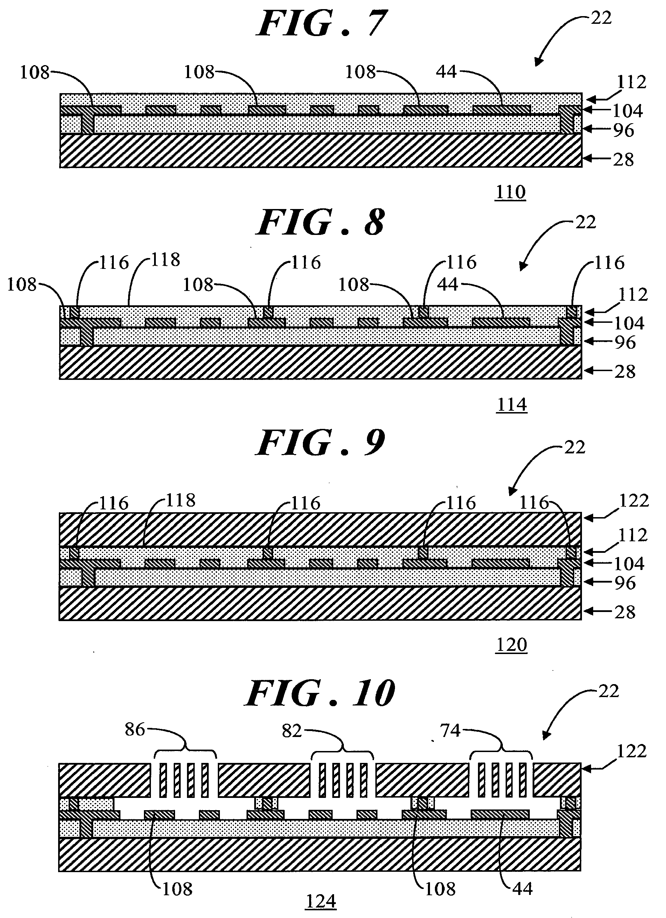

A more complete understanding of the present invention may be derived by referring to the detailed description and claims when considered in connection with the Figures, wherein like reference numbers refer to similar items throughout the Figures, the Figures are not necessarily drawn to scale, and:
FIG. 1 shows a sectional side view of a microelectromechanical systems (MEMS) sensor device having multiple stimulus sensing capability in accordance with an embodiment;
FIG. 2 shows a flowchart of a MEMS device fabrication process in accordance with another embodiment;
FIG. 3 shows a sectional side view of device structure of the MEMS sensor device at an initial stage of processing in accordance with the process of FIG. 2;
FIG. 4 shows a sectional side view of the device structure of FIG. 3 at a subsequent stage of processing;
FIG. 5 shows a sectional side view of the device structure of FIG. 4 at a subsequent stage of processing;
   WO-A1-2013/064632 provides a component with three sealed cavities, each containing a micromechanical structure, see figure 8 of WO-A1-2013/064632. The three sealed cavities may each have different gas pressures within them. This is achieved by closing off each cavity at a different time, with a different ambient gas pressure being applied at each of these times. US-A1-2012/5 0299127 provides a variety of sensors. A pressure sensor comprising a diaphragm may be formed in an integrated module with an accelerometer, with the diaphragm exposed to the environment by a through hole. A third angular rate sensor may be provided. EP-A1-2 506 017 relates to a sensor chip including acceleration sensors. The sensor chip is formed of a lower fixed plate, an upper fixed plate and a frame portion, which enclose the embedded accelerator sensors. Embedment electrodes extend through the upper fixed plate into cavities comprising rotationally supported rectangular parallelepiped weight portions; see fig. 3b.
FIG. 6 shows a sectional side view of the device structure of FIG. 5 at a subsequent stage of processing;
FIG. 7 shows a sectional side view of the device structure of FIG. 6 at a subsequent stage of processing;
FIG. 8 shows a sectional side view of the device structure of FIG. 7 at a subsequent stage of processing;
FIG. 9 shows a sectional side view of the device structure of FIG. 8 at a subsequent stage of processing;
FIG. 10 shows a sectional side view of the device structure of FIG. 9 at a subsequent stage of processing;

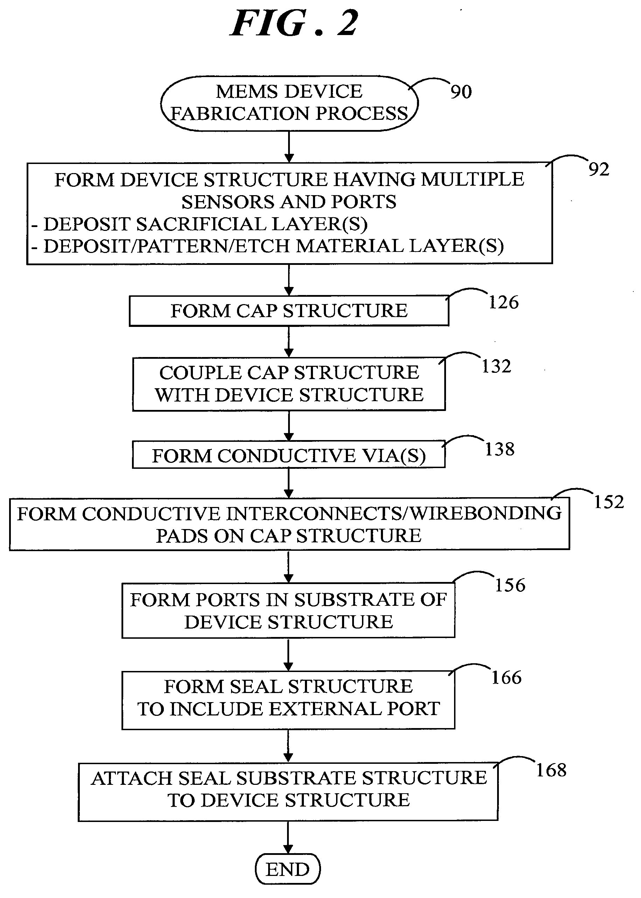

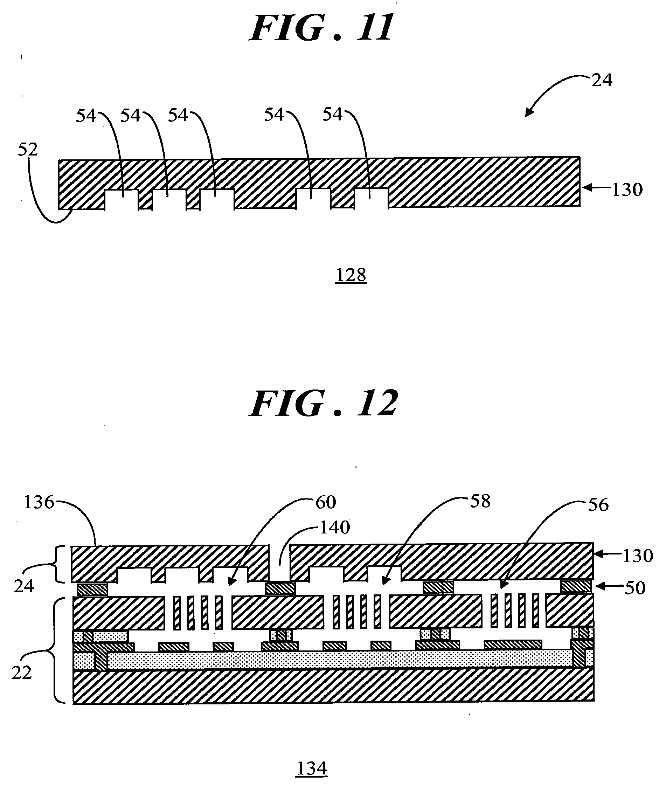

FIG. 11 shows a sectional side view of a cap structure of the MEMS sensor device at an initial stage of processing in accordance with the process of FIG. 2;
FIG. 12 shows a sectional side view of the cap structure of FIG. 11 coupled with the device structure of FIG. 10 at a subsequent stage of processing;

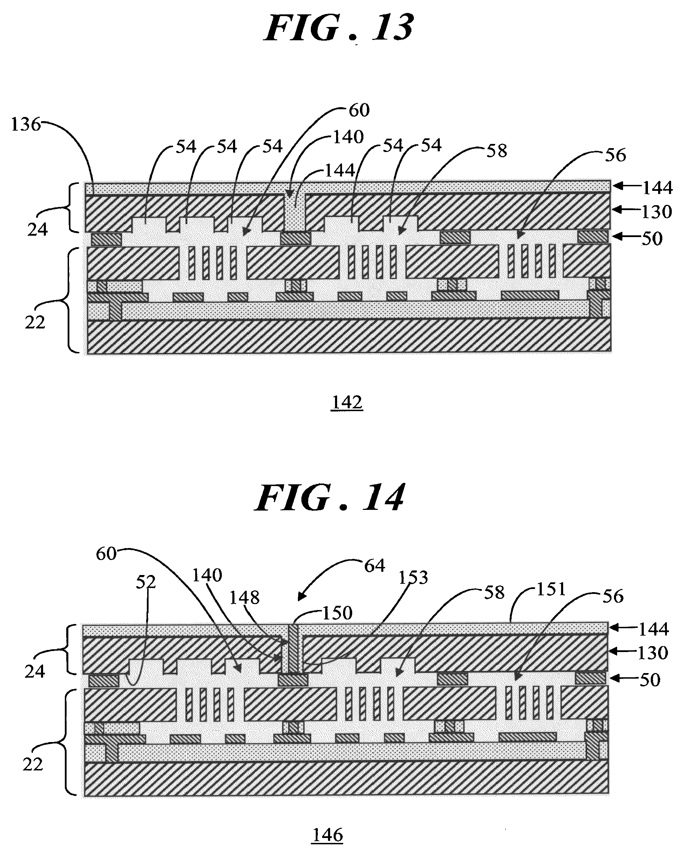

FIG. 13 shows a sectional side view of the device structure and cap structure of FIG. 12 at a subsequent stage of processing;
FIG. 14 shows a sectional side view of the device structure and cap structure of FIG. 13 at a subsequent stage of processing;

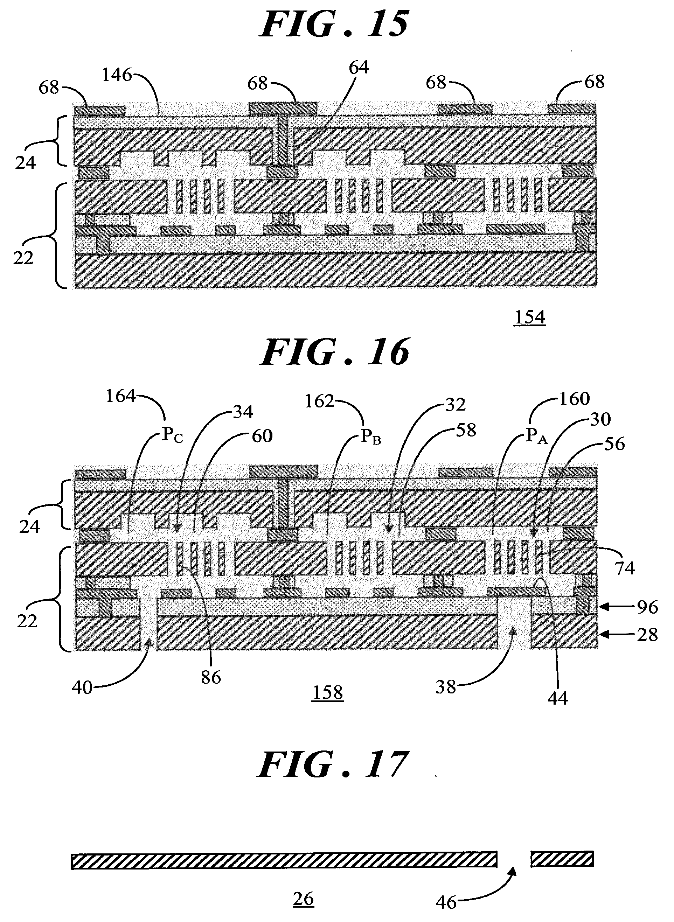

FIG. 15 shows a sectional side view of the cap structure and the device structure of FIG. 14 at a subsequent stage of processing;
FIG. 16 shows a sectional side view of the cap structure and the device structure of FIG. 15 at a subsequent stage of processing; and
FIG. 17 shows a sectional side view of a seal structure of the MEMS sensor device fabricated in accordance with the process of FIG. 2.

### Detailed Description

As the uses for MEMS sensor devices continue to grow and diversify, increasing emphasis is being placed on the development of advanced silicon MEMS sensor devices capable of sensing different physical stimuli at enhanced sensitivities and for integrating these sensors into the same package. In addition, increasing emphasis is being placed on fabrication methodology for MEMS sensor devices that achieves multiple stimulus sensing capability without increasing manufacturing cost and complexity and without sacrificing part performance. Forming a sensor having multiple stimulus sensing capability in a miniaturized package has been sought for use in a number of applications. Indeed, these efforts are primarily driven by existing and potential high-volume applications in automotive, medical, commercial, and consumer products.

An embodiment entails a microelectromechanical systems (MEMS) sensor device capable of sensing different physical stimuli. In particular, the MEMS sensor device includes laterally spaced integrated sensors, each of which may sense a different physical stimulus. In an embodiment, one sensor of the MEMS sensor device is a pressure sensor that uses a diaphragm and a pressure cavity to create a variable capacitor to detect strain (or deflection) due to applied pressure over an area. Other sensors of the MEMS sensor device may be inertial sensors, such as an accelerometer, gyroscope, and so forth that are capable of creating a variable capacitance in response to sensed motion stimuli. A MEMS sensor device with multi-stimulus sensing capability can be implemented within an application calling for six or more degrees of freedom for automotive, medical, commercial, and industrial markets.

Fabrication methodology for the MEMS sensor device entails a stacked configuration of three structures with laterally spaced sensors interposed between two of the structures. The laterally spaced sensors can include any suitable combination of, for example, a pressure sensor, accelerometers, and/or angular rate sensors. However, other sensors and MEMS devices may be incorporated as well. In an embodiment, the fabrication methodology enables the sensors to be located in separate isolated cavities that exhibit different cavity pressures for optimal operation of each of the sensors. Through-silicon vias may be implemented to eliminate the bond pad shelf of some MEMS sensor devices, thereby reducing MEMS sensor device dimensions and enabling chip scale packaging. Accordingly, fabrication methodology described herein may yield a MEMS multiple stimulus sensor device with enhanced sensitivity, reduced dimensions, that is durable, and that can be cost effectively fabricated utilizing existing manufacturing techniques.

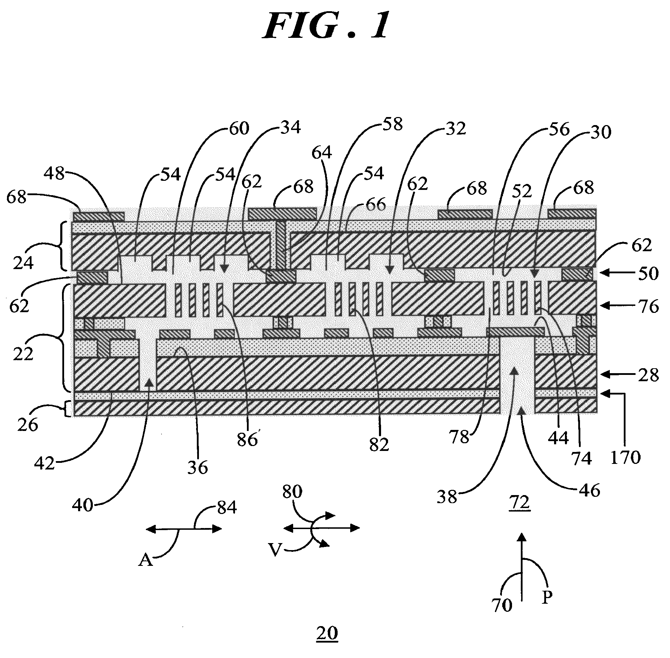

FIG. 1 shows a sectional side view of a microelectromechanical systems (MEMS) sensor device 20 having multiple stimulus sensing capability in accordance with an embodiment. FIG. 1 and subsequent FIGs. 3-17 are illustrated using various shading and/or hatching to distinguish the different elements of MEMS sensor device 20, as will be discussed below. These different elements within the structural layers may be produced utilizing current and upcoming micromachining techniques of depositing, patterning, etching, and so forth.

MEMS sensor device 20 includes a device structure 22, a cap structure 24 coupled with device structure 22, and a seal structure 26 attached to device structure 22. In an embodiment, device structure 22 includes a substrate layer 28, a pressure sensor 30, an angular rate sensor 32, and an accelerometer 34. Alternative embodiments may include different sensors than those described herein. Sensors 30, 32, 34 are formed on a top side 36 of substrate layer 28, and are laterally spaced apart from one another. Cap structure 24 is coupled with device structure 22 such that each of sensors 30, 32, and 34 are interposed between substrate layer 28 and cap structure 24.

Device structure 22 further includes ports 38, 40 formed in a bottom side 42 of substrate layer 28. More particularly, port 38 extends through substrate layer 28 from bottom side 42 and is aligned with a sense element 44 of pressure sensor 30 such that sense element 44 spans fully across port 38. Port 40 extends through substrate layer 28 underlying accelerometer 34. Seal structure 26 includes an external port 46 extending through seal structure 26. In accordance with an embodiment, seal structure 26 is attached to bottom side 42 of substrate layer 28 such that port 40 is hermetically sealed by seal structure 26 and external port 46 is aligned with port 38.

In some embodiments, cap structure 24 is coupled to a top surface 48 of device structure 22 using an electrically conductive bonding layer 50 that forms a conductive interconnection between device structure 22 and cap structure 24. Conductive bonding layer 50 may be, for example, an Aluminum-Germanium (Al-Ge) bonding layer, a Gold-Tin (Au-Sn) bonding layer, a Copper-Copper (Cu-Cu) bonding layer, a Copper-Tin (Cu-Sn) bonding layer, an Aluminum-Silicon (Al-Si) bonding layer, and so forth. Conductive bonding layer 50 may be suitably thick so that a bottom side 52 of cap structure 24 is displaced away from and does not contact top surface 48 of device structure 22 thereby producing at least one hermetically sealed cavity in which sensors 30, 32, 34 are located. In some configurations, cap structure 24 may additionally have cavity regions 54 extending inwardly from bottom side 52 of cap structure 24 to enlarge (i.e., deepen) the at least one hermetically sealed cavity.

In the illustrated embodiment, MEMS sensor device 20 includes three physically isolated and hermetically sealed cavities 56, 58, 60. That is, conductive bonding layer 50 is formed to include multiple sections 62 defining boundaries between the physically isolated cavities 56, 58, 60. In the exemplary embodiment, pressure sensor 30 is located in cavity 56, angular rate sensor 32 is located cavity 58, and accelerometer 34 is located in cavity 60. As further illustrated, cap structure 24 includes inwardly extending cavity regions 54 in each of cavities 58, 60 in which angular rate sensor 32 and accelerometer 34 reside.

Cap structure 24 may further include at least one electrically conductive through-silicon via (TSV) 64, also known as a vertical electrical connection (one shown), extending through cap structure 24 from bottom side 52 of cap structure 24 to a top side 66 of cap structure 24. Conductive via 64 may be electrically coupled with conductive bonding layer 50. Additionally, conductive via 64 may be electrically coupled to a conductive interconnect 68 formed on top side 66 of cap structure 24. Conductive interconnect 68 represents any number of wire bonding pads or an electrically conductive traces leading to wire bonding pads formed on top side 66 of cap structure 24. Accordingly, conductive interconnects 68 can be located on top side 66 of cap structure 24 in lieu of their typical location laterally displaced from, i.e., beside, device structure 22 on a bond pad shelf. As such, in an embodiment, conductive interconnects 68 may be attached to a circuit board where MEMS sensor device 20 is packaged in a flip chip configuration. Such vertical integration effectively reduces the footprint of MEMS sensor device 20 relative to some prior art MEMS sensor devices. Only one conductive via 64 is shown for simplicity of illustration. However, it should be understood that MEMS sensor device 20 may include multiple conductive vias 64, where one each of conductive vias 64 is suitably electrically connected to a particular section 62 of conductive bonding layer 50.

In an embodiment, pressure sensor 30 is configured to sense a pressure stimulus (P), represented by an arrow 70, from an environment 72 external to MEMS sensor device 20. Pressure sensor 30 includes a reference element 74 formed in a structural layer 76 of device structure 22. Reference element 74 may include a plurality of openings 78 extending through structural layer 76 of device structure 22. Sense element 44, also referred to as a diaphragm, for pressure sensor 30 is aligned with reference element 74, and is spaced apart from reference element 74 so as to form a gap between sense element 44 and reference element 74. Thus, when cap structure 24, device structure 22, and seal structure 26 are coupled in a vertically stacked arrangement, sense element 44 is interposed between reference element 74 in cavity 56 and port 38. Sense element 44 is exposed to external environment 72 via port 38 and external port 46, and is capable of movement in a direction that is generally perpendicular to a plane of device structure 22 in response to pressure stimulus 70 from external environment 72.

Pressure sensor 30 uses sense element 44 and the pressure within cavity 56 (typically less than atmospheric pressure) to create a variable capacitor to detect strain due to applied pressure, i.e., pressure stimulus 70. As such, pressure sensor 30 senses pressure stimulus 70 from environment 72 as movement of sense element 44 relative to reference element 74. A change in capacitance between reference element 74 and sense element 44 as a function of pressure stimulus 70 can be registered by sense circuitry (not shown) and converted to an output signal representative of pressure stimulus 70.

In this exemplary embodiment, angular rate sensor 32 and accelerometer 34 represent inertial sensors of MEMS sensor device 20. Angular rate sensor 32 is configured to sense an angular rate stimulus, or velocity (V), represented by a curved bi-directional arrow 80. In the exemplary configuration, angular rate sensor 32 includes a movable element 82. In general, angular rate sensor 32 is adapted to sense angular rate stimulus 80 as movement of movable element 82 relative to fixed elements (not shown). A change in a capacitance between the fixed elements and movable element 82 as a function of angular rate stimulus 80 can be registered by sense circuitry (not shown) and converted to an output signal representative of angular rate stimulus 80.

Accelerometer 34 is configured to sense a linear acceleration stimulus (A), represented by a bi-directional arrow 84. Accelerometer 34 includes a movable element 86. In general, accelerometer 34 is adapted to sense linear acceleration stimulus 84 as movement of movable element 86 relative to fixed elements (not shown). A change in a capacitance between the fixed elements and movable element 86 as a function of linear acceleration stimulus 84 can be registered by sense circuitry (not shown) and converted to an output signal representative of linear acceleration stimulus 84.

Only generalized descriptions of single axis inertial sensors, i.e., angular rate sensor 32 and accelerometer 34 are provided herein for brevity. It should be understood that in alternative embodiments, angular rate sensor 32 can be any of a plurality of single and multiple axis angular rate sensor structures configured to sense angular rate about one or more axes of rotation. Likewise, accelerometer 34 can be any of a plurality of single and multiple axis accelerometer structures configured to sense linear motion in one or more directions. In still other embodiments, sensors 32 and 34 may be configured to detect other physical stimuli, such as a magnetic field sensing, optical sensing, electrochemical sensing, and so forth.

Various MEMS sensor device packages include a sealed cap that covers the MEMS devices and seals them from moisture and foreign materials that could have deleterious effects on device operation. Additionally, some MEMS devices have particular pressure requirements in which they most effectively operate. For example, a MEMS pressure sensor is typically fabricated so that the pressure within its cavity is below atmospheric pressure, and more particularly near vacuum. Angular rate sensors may also most effectively operate in a vacuum atmosphere in order to achieve a high quality factor for low voltage operation and high signal response. Conversely, other types of MEMS sensor devices should operate in a non-vacuum environment in order to avoid an underdamped response in which movable elements of the device can undergo multiple oscillations in response to a single disturbance. By way of example, an accelerometer may require operation in a damped mode in order to reduce shock and vibration sensitivity. Therefore, multiple sensors in a single package may have different pressure requirements for the cavities in which they are located.

Accordingly, methodology described in detail below provides a technique for fabricating a space efficient, multi-stimulus MEMS sensor device, such as MEMS sensor device 20, in which multiple sensors can be integrated on a single chip, but can be located in separate isolated cavities that exhibit different cavity pressures suitable for effective operation of each of the sensors. Moreover, the multi-stimulus MEMS sensor device can be cost effectively fabricated utilizing existing manufacturing techniques.

FIG. 2 shows a flowchart of a MEMS device fabrication process 90 for producing a multi-stimulus MEMS sensor device, such as MEMS sensor device 20, in accordance with another embodiment. Process 90 generally describes methodology for concurrently forming the elements of the laterally spaced sensors 30, 32, 34. Fabrication process 90 implements known and developing MEMS micromachining technologies to cost effectively yield MEMS sensor device 20 having multiple stimulus sensing capability. Fabrication process 90 is described below in connection with the fabrication of a single MEMS sensor device 20. However, it should be understood by those skilled in the art that the following process allows for concurrent wafer-level manufacturing of a plurality of MEMS sensor devices 20. The individual devices 20 can then be separated, cut, or diced in a conventional manner to provide individual MEMS sensor devices 20 that can be packaged and integrated into an end application.

MEMS device fabrication process 90 begins with a task 92. At task 92, fabrication processes related to the formation of device structure 22 are performed. Exemplary fabrication processes related to the formation of device structure 22 are described in connection with FIGs. 3-10.

Referring now to FIG. 3, FIG. 3 shows a sectional side view of device structure 22 of MEMS sensor device 20 at an initial stage 94 of processing in accordance with fabrication process 90 of FIG. 2. In an embodiment, substrate layer 28 of device structure 22 may be a silicon wafer. Substrate layer 28 may be provided with an insulating layer 96 of, for example, a silicon oxide. Insulating layer 96 may be formed on top side 36 of substrate layer 28 by performing a thermal oxidation of silicon microfabrication process or any other suitable process. Other fabrication activities may be performed per convention that are not discussed or illustrated herein for clarity of description.

FIG. 4 shows a sectional side view of device structure 22 of FIG. 3 at a subsequent stage 98 of processing. At stage 98, portions of insulating layer 96 may be removed in accordance with a particular design configuration using any suitable etch process to form openings 100 extending through insulating layer 96 to surface 36 of substrate layer 28.

FIG. 5 shows a sectional side view of the device structure 22 of FIG. 4 at a subsequent stage 102 of processing. At stage 102, a material layer 104 is formed over insulating layer 96 and in openings 100. Material layer 104 may be formed by, for example, chemical vapor deposition, physical vapor deposition, or any other suitable process. Material layer 104 may be, for example, polycrystalline silicon also referred to as polysilicon or simply poly, although other suitable materials may alternatively be utilized to form material layer 104.

FIG. 6 shows a sectional side view of device structure 22 of FIG. 5 at a subsequent stage 106 of processing. At stage 106, material layer 104 may be selectively patterned and etched to form sense element 44 of pressure sensor 30 (FIG. 1) of MEMS sensor device (FIG. 1). In addition, material layer 104 may be selectively patterned and etched to form one or more components 108 of angular rate sensor 32 and accelerometer 34 (FIG. 1). These components 108 can include, for example, electrode elements, conductive traces, conductive pads, and so forth, in accordance with predetermined design requirements. Material layer 104 may additionally be thinned and polished by performing, for example, Chemical-Mechanical Planarization (CMP) or another suitable process to yield sense element 44 (i.e., the diaphragm for pressure sensor 30) and one or more components 108 of angular rate sensor and accelerometer 34.

FIG. 7 shows a sectional side view of device structure 22 of FIG. 6 at a subsequent stage 110 of processing. At stage 110, an insulating layer, referred to herein as a sacrificial layer 112 may be deposited on sense element 44, components 108, and any exposed portions of the underlying insulating layer 96. Sacrificial layer 112 may be, for example, silicon oxide, phosphosilicate glass (PSG), or any other suitable material.

FIG. 8 shows a sectional side view of device structure 22 of FIG. 7 at a subsequent stage 114 of processing. At stage 114, portions of sacrificial layer 112 may be removed in accordance with a particular design configuration using any suitable etch process to form openings extending through sacrificial layer 112 to, for example, particular components 108 formed in material layer 104. Additionally at stage 114, the openings may be filed with a conductive material such as polycrystalline silicon or another suitable material to form one or more conductive junctions 116 extending from, for example, some of components 108 in material layer 104 to a surface 118 of sacrificial layer 112.

FIG. 9 shows a sectional side view of device structure of FIG. 8 at a subsequent stage 120 of processing. At stage 120, a material layer 122 is formed over sacrificial layer 112 and conductive junctions 116. Like material layer 104, material layer 122 may be, for example, polycrystalline silicon or another suitable material that can be formed by, chemical vapor deposition, physical vapor deposition, or any other suitable process. In one embodiment, the material used to form conductive junctions 116 and material layer 122 can be the same and can be formed during the same process step.

FIG. 10 shows a sectional side view of the device structure of FIG. 9 at a subsequent stage 124 of processing. At stage 124, material layer 122 is patterned and etched using, for example, a Deep Reactive Ion Etch (DRIE) technique or any suitable process to form reference element 74 of pressure sensor 30 (FIG. 1), movable element 82 of angular rage sensor 32 (FIG. 1), movable element 86 of accelerometer 34 (FIG. 1), and any other elements of sensors 30, 32, and 34 in accordance with a particular design configuration of MEMS sensor device 20 (FIG. 1).

In addition, sacrificial layer 112 underlying reference element 74, movable element 82, and movable element 86 is removed to allow movement of, i.e., release, movable elements 82, 86, as wells as sense element 44, i.e., the diaphragm for pressure sensor 30. By way of example, an etch material, or etched, may be introduced into sensors 30, 32, 34 via the openings or spaces between reference element 74 and movable elements 82, 86 in a known manner in order to remove the underlying sacrificial layer 112.

Referring back to FIG. 2, following device structure formation task 92, MEMS device fabrication process 90 continues with a task 126. At task 126, fabrication processes related to the formation of cap structure 24 are performed. Exemplary fabrication processes related to the formation of cap structure 24 will be described in connection with FIGs. 11-14.

Referring now to FIG. 11, FIG. 11 shows a sectional side view of cap structure 24 of MEMS sensor device 20 (FIG. 1) at an initial stage 128 of processing in accordance with fabrication process 90 of FIG. 2. At initial stage 128, cavity regions 54 may be formed extending inwardly from bottom side 52 of a cap substrate 130 of cap structure 24. Cavity regions 54 may be formed using any suitable etch process. Cap substrate 130 may be a silicon wafer material. Alternatively, cap substrate 130 may be an application specific integrated circuit (ASIC) containing electronics associated with MEMS sensor device 20, in which the features of cap structure 24 are also formed.

Returning back to FIG. 2, following task 126, MEMS device fabrication process 90 continues with a task 132. At task 132, cap structure 24 is coupled with device structure 22.

Referring to FIG. 12 in connection with tasks 126 and 132 of process 90, FIG. 12 shows a sectional side view of cap structure 24 of FIG. 11 coupled with device structure 22 of FIG. 10 in accordance with task 132 at a subsequent stage of processing 134 in accordance with process 90. In particular, conductive bonding layer 50 is formed between device structure 22 and cap structure 24. In an embodiment, conductive bonding layer 50 may be an Al-Ge, gold (Au), or any of a variety of bonding materials mentioned above. Coupling may occur using a eutectic bonding technique, a thermal compression bonding technique, or any suitable bonding technique.

In an embodiment, coupling task 132 is performed under vacuum conditions. Thus, once bonded, cavities 56, 58, and 60 are formed with evacuated pressure. That is, the pressure within each of cavities 56, 58, and 60 is significantly less than ambient or atmospheric pressure. In general, conductive bonding layer 50 entirely encircles the perimeter of each cavity 56, 58, and 60. Accordingly, conductive bonding layer 50 not only forms the hermetic seal for each of cavities 56, 58, and 60, but will facilitate the conductive interconnection between the structures of the MEMS device structure 22 and those on an outer surface 136 of cap structure 24 (discussed below). After cap structure 24 is coupled with MEMS device structure 22, outer surface 136 of cap structure 24 may be thinned to a target thickness.

With reference back to FIG. 2, fabrication process 90 continues with a task 138 following coupling task 132. At task 138, conductive vias 64 (FIG. 1) can be formed in cap structure 24.

Referring to FIG. 12 in conjunction with task 138, task 138 commences with the formation of one or more openings 140 (one shown) extending through cap structure 24. Openings 140 may be formed extending through an entirety of cap substrate 130 using DRIE, KOH, or any suitable etch technique. Openings 140 are formed at the locations at which conductive vias 64 (FIG. 1) will be formed.

FIG. 13 shows a sectional side view of device structure 22 and cap structure 24 at a subsequent stage 142 of processing in accordance with task 138 of process 90 (FIG. 2). At stage 142, opening 140 is filled with an insulating material 144. Additionally, insulating material 144 may be formed on top surface 136 of cap substrate 130. Cap substrate 130 may be provided with one or more insulating layers to produce insulating material 144 that substantially fills opening 140 as well as provides an insulating layer on top surface 136 of cap substrate. Insulating material 144 can include a silicon oxide, a polymer layer, or any other suitable material.

FIG. 14 shows a sectional side view of device structure 22 and cap structure 24 at a subsequent stage 146 of processing in accordance with task 138 of process 90 (FIG. 2). At stage 146, an aperture 148 is formed extending through insulating material 144 residing in opening 140. A conductive material 150 is positioned in aperture 148 to form an electrically conductive connection between bottom side 52 of cap substrate 130 and an outer surface 151 of insulating material 144. This electrically conductive connection is conductive via 64 of MEMS sensor device 20 (FIG. 1). It should be noted that some insulating material 144 still lines an inner wall 153 of opening 140 to provide electrical insulation between cap substrate 130 and conductive via 64.

Tasks 126, 132, and 138 are provided to demonstrate one exemplary method for coupling cap structure 24 with device structure 22 as well as for forming conductive vias 64. In an alternative embodiment, openings 140 may be partially etched into cap substrate 130 from bottom side 52 (FIG. 11) of cap substrate 130 prior to coupling cap structure 24 with device structure 22. Openings 140 may then be filled with insulating material 144, and insulating material 144 may subsequently be etched to form apertures 148. Apertures 148 can then be filled with conductive material 150. Thereafter, cavity regions 54 may be formed in bottom side 52 of cap substrate 130. Next, cap structure 24 can be coupled with device structure 132 as described above in connection with task 132. Following the coupling process, cap structure 24 can be thinned from outer surface 136 (FIG. 13) to expose conductive material 150 within apertures 148 in order to form conductive vias 64.

With reference back to FIG. 2, following coupling task 132 and the formation of conductive vias 64 at task 138, MEMS device fabrication process 90 continues with a task 152. At task 152, conductive interconnects 68 (FIG. 1), e.g., wire bonding pads, conductive traces, and so forth, are formed on cap structure 24.

Referring to FIG. 15 in connection with task 152, FIG. 15 shows a sectional side view of the coupled cap structure 24 and device structure 22 of FIG. 14 at a subsequent stage 154 of processing. At stage 154, conductive interconnects 68 may be formed by the conventional processes of patterning, deposition, and etching of the appropriate materials to produce conductive interconnects 68 in the form of, for example, external metal interconnects and bond pads, on outer surface 146 of cap structure 24. Following execution of task 152, one or more conductive interconnects 68 may be coupled with associated ones of conductive vias 64 (one of which is shown).

With reference back to FIG. 2, following conductive interconnect formation task 152, MEMS device fabrication process 90 continues with a task 156. At task 156, ports 38, 40 (FIG. 1) are formed in substrate layer 28 (FIG. 1) of device structure 22.

Referring to FIG. 16 in connection with task 156, FIG. 16 shows a sectional side view of the coupled cap structure 24 and device structure 22 of FIG. 15 at a subsequent stage 158 of processing. As shown, ports 38, 40 extend through device substrate 28 and insulating layer 96. Ports 38, 40 can be formed by any appropriate etch process such as, for example, DRIE or KOH. In an embodiment, port 38 is formed to align with sense element 44 of pressure sensor 30. However, sense element 44 spans port 38 so that a cavity pressure 160, labeled P_{A}, of cavity 56 remains at vacuum. It should also be observed that a port does not breach cavity 58 for angular rate sensor 32. As such a cavity pressure 162, labeled P_{B}, for angular rate sensor 32 remains at vacuum.

In contrast to cavity 56 for pressure sensor 30 and cavity 58 for angular rate sensor 32, once port 40 is formed to fully extend through device substrate 28 and insulating layer 96, cavity 60 is breached. As such, a cavity pressure 164, labeled P_{C}, of cavity 60 for accelerometer 34 will change from vacuum to the ambient pressure of the environment in which MEMS sensor device 20 (FIG. 1) is currently located. That is, even though the cavity pressures 160, 162 remain at or near vacuum, cavity pressure 164 of cavity 60 for accelerometer 34 will differ from, and more particularly, will be significantly greater than cavity pressures 160, 162. Such capability is useful for venting cavity 60 to a particular design pressure, for cases where a different pressure level is needed for the optimal operation of accelerometer 34 than the pressure level needed for the optimal operation of pressure sensor 30 or angular rate sensor 32.

In some embodiments, certain materials may be introduced into cavity 60 for accelerometer 34 following the formation of port 40. For example, some design configurations may call for the deposition of an antistiction (i.e., a non-stick) coating on movable element 86 and/or on the surfaces surrounding movable element 86. The antistiction coating (not shown) may be introduced through port 40.

Referring back to MEMS device fabrication process 90 depicted in FIG. 2, following task 156, process 90 continues with a task 166. At task 166, seal structure 26 (FIG. 1) can be formed to include external port 46. Alternatively, seal structure 26 may be provided by an outside manufacturer with external port 46 already formed in seal structure 26.

With reference to FIG. 17 in connection with task 166, FIG. 17 shows a sectional side view of seal structure 26 of MEMS sensor device 20 (FIG. 1) fabricated in accordance with task 156 of process 90. Seal structure 26 may be a silicon substrate through which external port 46 may be etched or otherwise formed.

Referring back to MEMS device fabrication process 90 depicted in FIG. 2, following task 166, process 90 continues with a task 168. At task 168, seal structure 26 (FIG. 1) is attached to device structure 22 (FIG. 1). As such, attaching task 168 is performed following coupling task 150 as well as following port formation task 156 so that cavity pressures 160, 162, 164 (FIG. 16) within cavities 56, 58, and 60 are optimal for operation of the associated pressure sensor 30, angular rate sensor 32, and accelerometer 34.

Referring back to FIG. 1 in connection with task 168, a bonding layer 170 such as glass frit, a gold-tin metal eutectic layer, and so forth, may be formed between and couple seal structure 26 to bottom side 42 of substrate layer 28. Seal structure 26 is positioned such that seal structure 26 hermetically seals port 40. Accordingly, accelerometer sensor 34 and cavity 60 are temporarily exposed to external environment 72 via port 40 prior to attachment of seal structure 26 to bottom side 42, but are no long exposed to environment 72 following task 168. In contrast, is aligned with port 38 so that sense element 44 remains exposed to external environment 72 via port 38 and external port 46 following execution of task 168.

Attachment of seal structure 26 to device structure 24 effectively seals port 40, after cavity 60 has been vented to a suitable cavity pressure 164 (FIG. 16), so that moisture and foreign materials cannot gain access to accelerometer, where these foreign materials might otherwise have deleterious effects on accelerometer 34 operation. Following the attachment of seal structure 26 to device structure 24 at task 168, the fabrication of a multi-stimulus MEMS sensor device through the execution of process 90 is complete and process 90 ends.

The above methodology and configuration of MEMS sensor device 20 includes three cavities in which each individual sensor is housed in its own cavity. Furthermore, MEMS sensor device 20 is described as including a pressure sensor, an angular rate sensor, and an accelerometer for exemplary purposes. In alternative embodiments, those sensors that can be operated under the same cavity pressure conditions may be housed in the same cavity. For example, a multi-stimulus MEMS sensor device may include an angular rate sensor and a pressure sensor residing in the same cavity. In still other embodiments, those sensors that are operable under different cavity pressure conditions can be housed in different cavities where the cavity pressure can be suitably controlled through the aforementioned MEMS sensor device fabrication process.

It is to be understood that certain ones of the process blocks depicted in FIG. 2 may be performed in parallel with each other or with performing other processes. In addition, it is to be understood that the particular ordering of the process blocks depicted in FIG. 2 may be modified, while achieving substantially the same result, with the exception being that the seal structure is attached to the device structure following coupling of the cap structure to the device substrate as well as following formation of the ports in the substrate layer of the device structure so that cavity pressures within particular cavities are optimal for operation of the particular sensor or sensors residing in those cavities. Accordingly, such modifications are intended to be included within the scope of the inventive subject matter. In addition, although a particular multi-stimulus sensor device configuration is described above, the methodology may be performed with multi-stimulus sensor devices having other architectures as well. These and other variations are intended to be included within the scope of the inventive subject matter.

Thus, a MEMS multi-stimulus sensor device and a method of producing the MEMS multi-stimulus sensor device have been described. In particular, the MEMS sensor device includes laterally spaced integrated sensors, each of which may sense a different physical stimulus. In an embodiment, one sensor of the MEMS sensor device is a pressure sensor that uses a diaphragm and a pressure cavity to create a variable capacitor to detect strain (or deflection) due to applied pressure over an area. Other sensors of the MEMS sensor device may be inertial sensors, such as an accelerometer, gyroscope, and so forth that are capable of creating a variable capacitance in response to sensed motion stimuli.

Fabrication methodology for the MEMS sensor device entails a stacked configuration of three structures with the laterally spaced sensors interposed between two of the structures. The fabrication methodology enables the sensors to be located in separate isolated cavities that exhibit different cavity pressures for optimal operation of each of the sensors. Through-silicon vias may be implemented to eliminate the bond pad shelf of some MEMS sensor devices, thereby reducing MEMS sensor device dimensions and enabling chip scale packaging. Accordingly, fabrication methodology described herein yields a MEMS multiple stimulus sensor device with enhanced sensitivity, reduced dimensions, that is durable, and that can be cost effectively fabricated utilizing existing manufacturing techniques.

While the principles of the inventive subject matter have been described above in connection with a specific apparatus and method, it is to be clearly understood that this description is made only by way of example and not as a limitation on the scope of the inventive subject matter. Further, the phraseology or terminology employed herein is for the purpose of description and not of limitation.

The foregoing description of specific embodiments reveals the general nature of the inventive subject matter sufficiently so that others can, by applying current knowledge, readily modify and/or adapt it for various applications without departing from the general concept. Therefore, such adaptations and modifications are within the meaning and range of equivalents of the disclosed embodiments. The inventive subject matter embraces all such alternatives, modifications, equivalents, and variations as fall within the scope of the appended claims.

## Claims

1. A method (90) of producing a microelectromechanical systems (MEMS) sensor device (20), comprising:
forming (92) a first structure (22) having a substrate layer (28), a first sensor (30), and a second sensor (34), said first and second sensors (30, 34) being positioned on a first side (36) of said substrate layer (28), and said second sensor (34) being laterally spaced apart from said first sensor (30);
coupling (132) a second structure (24) with said first structure (22) such that said first and second sensors (30, 34) are interposed between said substrate layer (28) and said second structure (24), wherein said second structure (24) includes a third side (66) and a fourth side (52);
forming (138) a conductive via (64) extending through an opening (140) of said second structure (24) from said third side (66) to said fourth side (52), wherein said opening (140) is filled with an insulating material lining an inner wall (153) of said opening (140) to provide electrical insulation between a cap substrate (130) of said second structure (24) and said conductive via (64);
forming (156) a first port (38) and a second port (40) in a second side (42) of said substrate layer (28), said first port (38) extending through said substrate layer (28) to expose a sense element (44) of said first sensor (30) to an external environment (72), and said second port (40) extending through said substrate layer (28) to temporarily expose said second sensor (34) to said external environment (72); and
attaching (168) a third structure (26) to said second side (42) of said substrate layer (28) such that said second port (40) is hermetically sealed by said third structure (26) and an external port (46) of said third structure (26) is aligned with said first port (38).

2. A method (90) as claimed in claim 1, wherein said cap substrate (130) of said second structure (24) is a silicon wafer material or an application specific integrated circuit, ASIC.

3. A method (90) as claimed in claim 1, further comprising:
forming (152) a conductive interconnect (68) on said third side (66) of said second structure (24), said conductive interconnect (68) being in electrical communication with said conductive via (64).

4. A method (90) as claimed in claim 1, wherein said coupling operation (132) comprises:
utilizing a conductive bonding layer (50) to form a conductive interconnection between said second structure (24) and said first structure (22), wherein said conductive via (64) is electrically coupled with said conductive bonding layer (50).

5. A method (90) as claimed in claim 1, wherein said coupling operation (132) produces at least one hermetically sealed cavity (56) in which said first and second sensors (30, 34) are located.

6. A method (90) as claimed in claim 5, wherein said at least one cavity includes a first cavity (56) and a second cavity (60), said second cavity (60) being physically isolated from said first cavity (56), and wherein said first sensor (30) is located in said first cavity (56) and said second sensor (34) is located in said second cavity (60).

7. A method (90) as claimed in claim 6, further comprising:
producing said first cavity (56) to have a first cavity pressure (160) that is different from a second cavity pressure (164) of said second cavity (60).

8. A method (90) as claimed in claim 6,
wherein said first sensor (30) is a pressure sensor, and said sense element (44) is a diaphragm interposed between said first cavity (56) and said first port (38), said diaphragm (44) is exposed to said external environment (72) via said first port (38) and said external port (46), said diaphragm (44) being movable in response to a pressure stimulus (70) from said external environment (72),
wherein said second sensor (34) is an inertial sensor having a movable element (86), said second sensor (34) being adapted to sense a motion stimulus (84) as movement of said movable element (86).

9. A method (90) as claimed in claim 1, wherein said attaching operation (168) is performed following said coupling operation (132).

10. A method (90) as claimed in claim 9, wherein said coupling operation (132) is performed under vacuum conditions to produce a first cavity (56) in which said first sensor (30) is located.

11. A method (90) as claimed in claim 1, wherein said first structure (22) further includes a third sensor (32) positioned on said first side (36) of said substrate layer (28) and laterally spaced apart from said first and second sensors (30, 34).

12. A method (90) as claimed in claim 11, wherein:
said first sensor (30) comprises a pressure sensor, said sense element (44) is a diaphragm interposed between a first cavity (56) and said first port (38), said diaphragm (44) is exposed to said external environment (72) via said first port (38) and said external port (46), said diaphragm (44) being movable in response to a pressure stimulus (70) from said external environment (72);
said second sensor (34) comprises an accelerometer having a first movable element (86), said accelerometer (34) being adapted to sense an acceleration stimulus (84) as movement of said first movable element (86); and
said third sensor (32) comprises an angular rate sensor having a second movable element (82), said angular rate sensor (32) being adapted to sense an angular rate stimulus (80) as movement of said second movable element (82).

13. A microelectromechanical systems (MEMS) sensor device (20), comprising:
a first structure (22) having a substrate layer (28), a first sensor (30), and a second sensor (34), said first and second sensors (30, 34) being positioned on a first side (36) of said substrate layer (28), said second sensor (34) being laterally spaced apart from said first sensor (30), and said first structure (22) further having a first port (38) and a second port (40) formed in a second side (42) of said substrate layer (28), said first port (38) extending through said substrate layer (28) to expose a sense element (44) of said first sensor (30) to an external environment (72), and said second port (40) extending through said substrate layer (28) to said second sensor (34);
a second structure (24) coupled with said first structure (22) to produce at least one hermetically sealed cavity (56) between said substrate layer (28) and said second structure (24) in which said first and second sensors (30, 34) are located, wherein said second structure (24) comprises a third side (66), a fourth side (52), and a conductive via (64) extending through an opening (140) of said second structure (24) from said third side (66) to said fourth side (52), wherein said opening (140) is filled with an insulating material lining an inner wall (153) of said opening (140) to provide electrical insulation between a substrate (130) of said second structure (24) and said conductive via (64); and
a third structure (26) having an external port (46) extending through said third structure (26), said third structure (26) being attached to said second side (42) of said substrate layer (28) such that said second port (40) is hermetically sealed by said third structure (26) and said external port (46) is aligned with said first port (38).

14. A MEMS sensor device (20) as claimed in claim 13, wherein said second structure (24) comprises:
a conductive interconnect (68) formed on said third side (66) of said second structure (24), said conductive interconnect (68) being in electrical communication with said conductive via (64).

15. A MEMS sensor device (20) as claimed in claim 13,
wherein said at least one cavity includes a first cavity (56) and a second cavity (60) physically isolated from said first cavity (56), said first cavity (56) having a cavity pressure (160) that is less than a second cavity pressure (164) of said second cavity (60),
wherein said first sensor (30) comprises a pressure sensor located in said first cavity (56), said sense element (44) is a diaphragm interposed between said first cavity (56) and said first port (38), said diaphragm (44) is exposed to said external environment (72) via said first port (38) and said external port (46), said diaphragm (44) being movable in response to a pressure stimulus (70) from said external environment (72),
wherein said second sensor (34) comprises an inertial sensor located in said second cavity (60), said inertial sensor (34) having a movable element (86), said second sensor (34) being adapted to sense a motion stimulus (84) as movement of said movable element (86).

## Patentansprüche

1. Ein Verfahren (90) zum Erzeugen einer mikroelektromechanisches-System (MEMS) Sensorvorrichtung (20), aufweisend:
Bilden (92) einer ersten Struktur (22), welche eine Substratschicht (28), einen ersten Sensor (30) und einen zweiten Sensor (34) hat, wobei der erste und der zweite Sensor (30, 34) auf einer ersten Seite (36) der Substratschicht (28) platziert sind, und wobei der zweite Sensor (34) von dem ersten Sensor (30) seitlich beabstandet ist;
Koppeln (132) einer zweiten Struktur (24) mit der ersten Struktur (22), so dass der erste und der zweite Sensor (30, 34) zwischen der Substratschicht (28) und der zweiten Struktur (24) angeordnet sind, wobei die zweite Struktur (24) eine dritte Seite (66) und eine vierte Seite (52) enthält;
Bilden (138) eines leitfähigen Vias (64), welches sich durch eine Öffnung (140) der zweiten Struktur (24) von der dritten Seite (66) zu der vierten Seite (52) erstreckt, wobei die Öffnung (140) mit einem isolierenden Material gefüllt ist, mit welchem eine innere Wand (153) der Öffnung (140) beschichtet ist, um eine elektrische Isolation zwischen einem Abdeck-Substrat (130) der zweiten Struktur (24) und dem leitfähigen Via (64) bereitzustellen;
Bilden (156) eines ersten Ports (38) und eines zweiten Ports (40) in einer zweiten Seite (42) der Substratschicht (28), wobei sich der erste Port (38) durch die Substratschicht (28) erstreckt, um ein Abtastelement (44) des ersten Sensors (30) einer externen Umgebung (72) auszusetzen, und wobei sich der zweite Port (40) durch die Substratschicht (28) erstreckt, um den zweiten Sensor (34) vorübergehend der externen Umgebung (72) auszusetzen; und
Befestigen (168) einer dritten Struktur (26) an der zweiten Seite (42) der Substratschicht (28), so dass der zweite Port (40) mittels der dritten Struktur (26) hermetisch abgedichtet ist und ein externer Port (46) der dritten Struktur (26) mit dem ersten Port (38) fluchtet.

2. Ein Verfahren (90) gemäß Anspruch 1, wobei das Abdeck-Substrat (130) der zweiten Struktur (24) ein Silizium Wafer Material oder ein anwendungsspezifischer integrierter Schaltkreis, ASIC, ist.

3. Ein Verfahren (90) gemäß Anspruch 1, ferner aufweisend:
Bilden (152) einer leitfähigen Verbindung (68) auf der dritten Seite (66) der zweiten Struktur (24), wobei die leitfähige Verbindung (68) in elektrischer Kommunikation mit dem leitfähigen Via (64) steht.

4. Ein Verfahren (90) gemäß Anspruch 1, wobei der Koppeln-Vorgang (132) aufweist:
Verwenden einer leitfähigen Bondschicht (50), um eine leitfähige Verbindung zwischen der zweiten Struktur (24) und der ersten Struktur (22) zu bilden, wobei das leitfähige Via (64) mit der leitfähigen Bondschicht (50) elektrisch gekoppelt ist.

5. Ein Verfahren (90) gemäß Anspruch 1, wobei der Koppeln-Vorgang (132) zumindest eine hermetisch abgedichtete Aussparung (56) erzeugt, in welcher sich der erste und der zweite Sensor (30, 34) befinden.

6. Ein Verfahren (90) gemäß Anspruch 5, wobei die zumindest eine Aussparung eine erste Aussparung (56) und eine zweite Aussparung (60) enthält, wobei die zweite Aussparung (60) von der ersten Aussparung (56) physisch isoliert ist, und wobei sich der erste Sensor (30) in der ersten Aussparung (56) befindet, und wobei sich der zweite Sensor (34) in der zweiten Aussparung (60) befindet.

7. Ein Verfahren (90) gemäß Anspruch 6, ferner aufweisend:
Erzeugen der ersten Aussparung (56), um einen ersten Aussparungsdruck (160) zu haben, welcher unterschiedlich ist von einem zweiten Aussparungsdruck (164) der zweiten Aussparung (60).

8. Ein Verfahren (90) gemäß Anspruch 6,
wobei der erste Sensor (30) ein Drucksensor ist und das Abtastelement (44) ein Diaphragma ist, welches zwischen der ersten Aussparung (56) und dem ersten Port (38) angeordnet ist,
wobei das Diaphragma (44) der externen Umgebung (72) via den ersten Port (38) und den externen Port (46) ausgesetzt ist,
wobei das Diaphragma (44) beweglich ist in Reaktion auf einen Druck Stimulus (70) von der externen Umgebung (72),
wobei der zweite Sensor (34) ein Inertialsensor ist, welcher ein bewegliches Element (86) hat,
wobei der zweite Sensor (34) eingerichtet ist, einen Bewegungsstimulus (84) als Bewegung des beweglichen Elements (86) abzutasten.

9. Ein Verfahren (90) gemäß Anspruch 1, wobei der Befestigen-Vorgang (168) auf den Koppeln-Vorgang (132) folgend durchgeführt wird.

10. Ein Verfahren (90) gemäß Anspruch 9, wobei der Koppeln-Vorgang (132) unter Vakuumbedingungen durchgeführt wird, um eine erste Aussparung (56) zu erzeugen, in welcher sich der erste Sensor (30) befindet.

11. Ein Verfahren (90) gemäß Anspruch 1, wobei die erste Struktur (22) ferner einen dritten Sensor (32) enthält, welcher auf der ersten Seite (36) der Substratschicht (28) platziert ist und von dem ersten und dem zweiten Sensor (30, 34) seitlich beabstandet ist.

12. Ein Verfahren (90) gemäß Anspruch 11, wobei:
der erste Sensor (30) einen Drucksensor aufweist, wobei das Abtastelement (44) ein Diaphragma ist, welches zwischen einer ersten Aussparung (56) und dem ersten Port (38) angeordnet ist, wobei das Diaphragma (44) der externen Umgebung (72) via den ersten Port (38) und den externen Port (46) ausgesetzt ist, wobei das Diaphragma (44) beweglich ist in Reaktion auf einen Druck Stimulus (70) von der externen Umgebung (72);
der zweite Sensor (34) einen Beschleunigungssensor aufweist, welcher ein erstes bewegliches Element (86) hat, wobei der Beschleunigungssensor (34) eingerichtet ist, einen Beschleunigungsstimulus (84) als Bewegung des ersten beweglichen Elements (86) abzutasten; und
der dritte Sensor (32) einen Drehratensensor aufweist, welcher ein zweites bewegliches Element (82) hat, wobei der Drehratensensor (32) eingerichtet ist, einen Drehraten Stimulus (80) als Bewegung des zweiten beweglichen Elements (82) abzutasten.

13. Eine mikroelektromechanisches-System (MEMS) Sensorvorrichtung (20) aufweisend:
eine erste Struktur (22), welche eine Substratschicht (28), einen ersten Sensor (30), und einen zweiten Sensor (34) hat,
wobei der erste und der zweite Sensor (30, 34) auf einer ersten Seite (36) der Substratschicht (28) platziert sind,
wobei der zweite Sensor (34) von dem ersten Sensor (30) seitlich beabstandet ist, und
wobei die erste Struktur (22) ferner einen ersten Port (38) und einen zweiten Port (40) hat, welche in einer zweiten Seite (42) der Substratschicht (28) gebildet sind,
wobei sich der erste Port (38) durch die Substratschicht (28) erstreckt, um ein Abtastelement (44) des ersten Sensors (30) einer externen Umgebung (72) auszusetzen, und
wobei sich der zweite Port (40) durch die Substratschicht (28) zu dem zweiten Sensor (34) erstreckt;
eine zweite Struktur (24), welche mit der ersten Struktur (22) gekoppelt ist, um zumindest eine hermetisch abgedichtete Aussparung (56) zwischen der Substratschicht (28) und der zweiten Struktur (24) zu erzeugen, in welcher sich der erste und der zweite Sensor (30, 34) befinden,
wobei die zweite Struktur (24) eine dritte Seite (66), eine vierte Seite (52) und ein leitfähiges Via (64) aufweist, welches sich durch eine Öffnung (140) der zweiten Struktur (24) von der dritten Seite (66) zu der vierten Seite (52) erstreckt,
wobei die Öffnung (140) mit einem isolierenden Material gefüllt ist, mit welchem eine innere Wand (153) der Öffnung (140) beschichtet ist, um eine elektrische Isolation zwischen einem Substrat (130) der zweiten Struktur (24) und dem leitfähigen Via (64) bereitzustellen; und
eine dritte Struktur (26), welche einen externen Port (46) hat, welcher sich durch die dritte Struktur (26) erstreckt,
wobei die dritte Struktur (26) an der zweiten Seite (42) der Substratschicht (28) befestigt ist, so dass der zweite Port (40) mittels der dritten Struktur (26) hermetisch abgedichtet ist und der externe Port (46) mit dem ersten Port (38) fluchtet.

14. Eine MEMS Sensorvorrichtung (20) gemäß Anspruch 13, wobei die zweite Struktur (24) aufweist:
eine leitfähige Verbindung (68), welche auf der dritten Seite (66) der zweiten Struktur (24) gebildet ist, wobei die leitfähige Verbindung (68) in elektrischer Kommunikation mit dem leitfähigen Via (64) steht.

15. Eine MEMS Sensorvorrichtung (20) gemäß Anspruch 13,
wobei die zumindest eine Aussparung eine erste Aussparung (56) und eine zweite Aussparung (60) enthält, welche physisch von der ersten Aussparung (56) isoliert ist, wobei die erste Aussparung (56) einen Aussparungsdruck (160) hat, der geringer ist als ein zweiter Aussparungsdruck (164) der zweiten Aussparung (60),
wobei der erste Sensor (30) einen Drucksensor aufweist, welcher sich in der ersten Aussparung (56) befindet, wobei das Abtastelement (44) ein Diaphragma ist, welches zwischen der ersten Aussparung (56) und dem ersten Port (38) angeordnet ist, wobei das Diaphragma (44) der externen Umgebung (72) via den ersten Port (38) und den externen Port (46) ausgesetzt ist, wobei das Diaphragma (44) beweglich ist in Reaktion auf einen Druck Stimulus (70) von der externen Umgebung (72),
wobei der zweite Sensor (34) einen Inertialsensor aufweist, welcher sich in der zweiten Aussparung (60) befindet, wobei der Inertialsensor (34) ein bewegliches Element (86) hat, wobei der zweite Sensor (34) eingerichtet ist, einen Bewegungsstimulus (84) als Bewegung des beweglichen Elements (86) abzutasten.

## Revendications

1. Procédé (90) de production d'un dispositif capteur (20) à systèmes microélectromécaniques (MEMS), comprenant :
la formation (92) d'une première structure (22) ayant une couche de substrat (28), un premier capteur (30) et un deuxième capteur (34), lesdits premier et deuxième capteurs (30, 34) étant positionnés sur un premier côté (36) de ladite couche de substrat (28), et ledit deuxième capteur (34) étant espacé latéralement dudit premier capteur (30) ;
le couplage (132) d'une deuxième structure (24) avec ladite première structure (22) de telle sorte que lesdits premier et deuxième capteurs (30, 34) soient intercalés entre ladite couche de substrat (28) et ladite deuxième structure (24), ladite deuxième structure (24) comportant un troisième côté (66) et un quatrième côté (52) ;
la formation (138) d'un trou d'interconnexion conducteur (64) s'étendant à travers une ouverture (140) de ladite deuxième structure (24) depuis ledit troisième côté (66) jusqu'audit quatrième côté (52), ladite ouverture (140) étant remplie avec un matériau isolant garnissant une paroi intérieure (153) de ladite ouverture (140) pour fournir une isolation électrique entre un substrat d'encapsulation (130) de ladite deuxième structure (24) et ledit trou d'interconnexion conducteur (64) ;
la formation (156) d'un premier orifice (38) et d'un deuxième orifice (40) dans un deuxième côté (42) de ladite couche de substrat (28), ledit premier orifice (38) s'étendant à travers ladite couche de substrat (28) pour exposer un élément de détection (44) dudit premier capteur (30) à un environnement externe (72), et ledit deuxième orifice (40) s'étendant à travers ladite couche de substrat (28) pour exposer temporairement ledit deuxième capteur (34) audit environnement externe (72) ; et
la fixation (168) d'une troisième structure (26) audit deuxième côté (42) de ladite couche de substrat (28) de telle sorte que ledit deuxième orifice (40) soit scellé hermétiquement par ladite troisième structure (26) et un orifice externe (46) de ladite troisième structure (26) soit aligné avec ledit premier orifice (38).

2. Procédé (90) selon la revendication 1, dans lequel ledit substrat d'encapsulation (130) de ladite deuxième structure (24) est un matériau de tranche de silicium ou un circuit intégré spécifique, ASIC.

3. Procédé (90) selon la revendication 1, comprenant en outre :
la formation (152) d'une interconnexion conductrice (68) sur ledit troisième côté (66) de ladite deuxième structure (24), ladite interconnexion conductrice (68) étant en communication électrique avec ledit trou d'interconnexion conducteur (64).

4. Procédé (90) selon la revendication 1, dans lequel ladite opération de couplage (132) comprend :
l'utilisation d'une couche de liaison conductrice (50) pour former une interconnexion conductrice entre ladite deuxième structure (24) et ladite première structure (22), ledit trou d'interconnexion conducteur (64) étant couplé électriquement avec ladite couche de liaison conductrice (50).

5. Procédé (90) selon la revendication 1, dans lequel ladite opération de couplage (132) produit au moins une cavité scellée hermétiquement (56) dans laquelle sont situés lesdits premier et deuxième capteurs (30, 34).

6. Procédé (90) selon la revendication 5, dans lequel ladite au moins une cavité comporte une première cavité (56) et une deuxième cavité (60), ladite deuxième cavité (60) étant isolée physiquement de ladite première cavité (56), et dans lequel ledit premier capteur (30) est situé dans ladite première cavité (56) et ledit deuxième capteur (34) est situé dans ladite deuxième cavité (60).

7. Procédé (90) selon la revendication 6, comprenant en outre :
la production de ladite première cavité (56) pour qu'elle ait une pression de première cavité (160) qui est différente d'une pression de deuxième cavité (164) de ladite deuxième cavité (60).

8. Procédé (90) selon la revendication 6,
dans lequel ledit premier capteur (30) est un capteur de pression, et ledit élément de détection (44) est une membrane intercalée entre ladite première cavité (56) et ledit premier orifice (38), ladite membrane (44) étant exposée audit environnement externe (72) par ledit premier orifice (38) et ledit orifice externe (46), ladite membrane (44) étant mobile en réponse à un stimulus de pression (70) provenant dudit environnement externe (72),
dans lequel ledit deuxième capteur (34) est un capteur inertiel ayant un élément mobile (86), ledit deuxième capteur (34) étant adapté pour détecter un stimulus de mouvement (84) comme un déplacement dudit élément mobile (86).

9. Procédé (90) selon la revendication 1, dans lequel ladite opération de fixation (168) est effectuée après ladite opération de couplage (132).

10. Procédé (90) selon la revendication 9, dans lequel ladite opération de couplage (132) est effectuée dans des conditions de vide pour produire une première cavité (56) dans laquelle est situé ledit premier capteur (30).

11. Procédé (90) selon la revendication 1, dans lequel ladite première structure (22) comporte en outre un troisième capteur (32) positionné sur ledit premier côté (36) de ladite couche de substrat (28) et espacé latéralement desdits premier et deuxième capteurs (30, 34).

12. Procédé (90) selon la revendication 11, dans lequel :
ledit premier capteur (30) comprend un capteur de pression, ledit élément de détection (44) est une membrane intercalée entre une première cavité (56) et ledit premier orifice (38), ladite membrane (44) est exposée audit environnement externe (72) par ledit premier orifice (38) et ledit orifice externe (46), ladite membrane (44) étant mobile en réponse à un stimulus de pression (70) provenant dudit environnement externe (72) ;
ledit deuxième capteur (34) comprend un accéléromètre ayant un premier élément mobile (86), ledit accéléromètre (34) étant adapté pour détecter un stimulus d'accélération (84) comme un déplacement dudit premier élément mobile (86) ; et
ledit troisième capteur (32) comprend un capteur de vitesse angulaire ayant un deuxième élément mobile (82), ledit capteur de vitesse angulaire (32) étant adapté pour détecter un stimulus de vitesse angulaire (80) comme un déplacement dudit deuxième élément mobile (82).

13. Dispositif capteur (20) à systèmes microélectromécaniques (MEMS), comprenant :
une première structure (22) ayant une couche de substrat (28), un premier capteur (30) et un deuxième capteur (34), lesdits premier et deuxième capteurs (30, 34) étant positionnés sur un premier côté (36) de ladite couche de substrat (28), ledit deuxième capteur (34) étant espacé latéralement dudit premier capteur (30), et ladite première structure (22) ayant en outre un premier orifice (38) et un deuxième orifice (40) formés dans un deuxième côté (42) de ladite couche de substrat (28), ledit premier orifice (38) s'étendant à travers ladite couche de substrat (28) pour exposer un élément de détection (44) dudit premier capteur (30) à un environnement externe (72), et ledit deuxième orifice (40) s'étendant à travers ladite couche de substrat (28) jusqu'audit deuxième capteur (34) ;
une deuxième structure (24) couplée avec ladite première structure (22) pour produire au moins une cavité scellée hermétiquement (56) entre ladite couche de substrat (28) et ladite deuxième structure (24) dans laquelle sont situés lesdits premier et deuxième capteurs (30, 34), ladite deuxième structure (24) comprenant un troisième côté (66), un quatrième côté (52), et un trou d'interconnexion conducteur (64) s'étendant à travers une ouverture (140) de ladite deuxième structure (24) depuis ledit troisième côté (66) jusqu'audit quatrième côté (52), ladite ouverture (140) étant remplie avec un matériau isolant garnissant une paroi intérieure (153) de ladite ouverture (140) pour fournir une isolation électrique entre un substrat (130) de ladite deuxième structure (24) et ledit trou d'interconnexion conducteur (64) ; et
une troisième structure (26) ayant un orifice externe (46) s'étendant à travers ladite troisième structure (26), ladite troisième structure (26) étant fixée audit deuxième côté (42) de ladite couche de substrat (28) de telle sorte que ledit deuxième orifice (40) est scellé hermétiquement par ladite troisième structure (26) et ledit orifice externe (46) est aligné avec ledit premier orifice (38).

14. Dispositif capteur MEMS (20) selon la revendication 13, dans lequel ladite deuxième structure (24) comprend :
une interconnexion conductrice (68) formée sur ledit troisième côté (66) de ladite deuxième structure (24), ladite interconnexion conductrice (68) étant en communication électrique avec ledit trou d'interconnexion conducteur (64).

15. Dispositif capteur MEMS (20) selon la revendication 13,
dans lequel ladite au moins une cavité comporte une première cavité (56) et une deuxième cavité (60) isolée physiquement de ladite première cavité (56), ladite première cavité (56) ayant une pression de cavité (160) qui est inférieure à une pression de deuxième cavité (164) de ladite deuxième cavité (60),
dans lequel ledit premier capteur (30) comprend un capteur de pression situé dans ladite première cavité (56), ledit élément de détection (44) est une membrane intercalée entre ladite première cavité (56) et ledit premier orifice (38), ladite membrane (44) est exposée audit environnement externe (72) par ledit premier orifice (38) et ledit orifice externe (46), ladite membrane (44) étant mobile en réponse à un stimulus de pression (70) provenant dudit environnement externe (72),
dans lequel ledit deuxième capteur (34) comprend un capteur inertiel situé dans ladite deuxième cavité (60), ledit capteur inertiel (34) ayant un élément mobile (86), ledit deuxième capteur (34) étant adapté pour détecter un stimulus de mouvement (84) comme un déplacement dudit élément mobile (86).
